(19) Europäisches Patentamt
European Patent Office
Office européen des brevets

(11) Veröffentlichungsnummer : **0 048 219**
**B1**

# (12) EUROPÄISCHE PATENTSCHRIFT

(45) Veröffentlichungstag der Patentschrift : **01.10.86**

(51) Int. Cl.⁴ : **H 05 K 1/05, C 08 G 73/14**

(21) Anmeldenummer : **81810370.7**

(22) Anmeldetag : **09.09.81**

(54) **Verwendung von flexiblem Basismaterial zur Herstellung von gedruckten Schaltungen.**

(30) Priorität : **15.09.80 CH 6904/80**
**03.07.81 CH 4397/81**

(43) Veröffentlichungstag der Anmeldung : **24.03.82 Patentblatt 82/12**

(45) Bekanntmachung des Hinweises auf die Patenterteilung : **01.10.86 Patentblatt 86/40**

(84) Benannte Vertragsstaaten : **AT CH DE FR GB IT LI NL**

(56) Entgegenhaltungen :
**DE-A- 2 342 454**
**DE-A- 2 342 464**
**FR-A- 2 128 376**
**GB-A- 1 444 421**
**US-A- 3 809 591**
**CHEMICAL ABSTRACTS, Band 87, Nr. 10, 5. September 1977, Seite 643, Nr. 77490p, Columbus, Ohio, USA**
**CHEMICAL ABSTRACTS, Band 86, Nr. 22, 30. Mai 1977, Seite 94, Nr. 157218a, Columbus, Ohio, USA**
**Hochtemperatur beständige Kunststoffe, Karl Hansen Verlag München 1969**

(73) Patentinhaber : **CIBA-GEIGY AG**
**Klybeckstrasse 141**
**CH-4002 Basel (CH)**

(72) Erfinder : **Darms, Roland, Dr.**
**Kleinfeldweg 3**
**CH-4106 Therwil (CH)**
Erfinder : **Haug, Theobald, Dr.**
**Untere Flühackerstrasse 12**
**CH-4402 Frenkendorf (CH)**
Erfinder : **Beyeler, Harry**
**Magnolienpark 18**
**CH-4052 Basel (CH)**

**EP 0 048 219 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die vorliegende Erfindung betrifft die Verwendung von flexiblen Basismaterialien aus mit Polyamid-Polyimid-Blockcopolymeren oder Polyamid-Polyimid-Copolymeren beschichteter Kupferfolie zur Herstellung von flexiblen gedruckten Schaltungen.

Flexible gedruckte Schaltungen bieten gegenüber den starren gedruckten Schaltungen bekanntlich viele technische Vorteile. Sie lassen sich besser handhaben, da sie praktisch in jeder Form als elektronisches Bauelement in das System eingefügt werden können, benötigen dadurch weniger Platz im elektrischen Gerät und sind auch unempfindlicher gegenüber Vibrationen.

An das flexible Basismaterial, die mit einem Isolierstoff beschichtete Metallfolie, welche zur Herstellung von gedruckten Schaltungen verwendet wird, werden allerdings hohe Anforderungen gestellt. Die Beschichtung muss eine sehr gute Haftung auf der Metallfolie aufweisen, und die Arbeitsprozesse bei der Herstellung von gedrukten Schaltungen schadlos überstehen, das heisst, die Beschichtung muss eine gute Lötbadbeständigkeit aufweisen sowie eine gute Beständigkeit gegenüber den in der Leiterplattentechnologie eingesetzten Lösungsmitteln. Das flexible Basismaterial muss ferner gebogen, gerollt, verdreht und gefaltet werden können, ohne dass es bei der Beschichtung zur Rissbildung kommt.

Es ist bekannt, Metallfolien mit Polyimidfolien zu beschichten, indem man die Polyimidfolie auf eine mit einem Bindemittel versehene Kupferfolie aufkaschiert. Die auf diese Weise hergestellten, eine Bindemittelschicht enthaltende Laminate erfüllen nicht in jeder Hinsicht die zuvor genannten Anforderungen ; insbesondere lassen die elektrischen Eigenschaften zu wünschen übrig.

Aus dem US-A-3 682 960 ist es ferner bekannt, Metalle mit einer Mischung aus einer Polyamidsäure und einer mit Amiden modifizierten Polyamidsäure zu beschichten. Die nach dem Erhitzen auf den Metallen erhaltenen Beschichtungen aus Polyimiden und Polyamidimiden weisen aber den Nachteil auf, dass sie nicht genügend flexibel sind und leicht von der Metallfolie abkanten.

Um diese Nachteile zu umgehen, wird deshalb im US-A-4 148 969 vorgeschlagen, Laminate aus mit Polyparabansäuren beschichteten Metallfolien zu verwenden, wobei die verwendete Polyparabansäure durch Hydrolyse des Reaktionsproduktes von Diphenylmethandiisocyanat mit Cyanwasserstoff hergestellt wird. Abgesehen davon, dass die Herstellung von der verwendeten Polyparabansäure kompliziert ist, muss man in der Vorstufe mit Cyanwasserstoff arbeiten, wobei zusätzliche Vorsichtsmassnahmen getroffen werden müssen.

Es wurde nun gefunden, dass man auf eine einfachere Art flexible gedruckte Schaltungen erhält, wenn man flexible Basismaterialien aus auf Kupferfolie ohne Zwischenschicht fest haftenden Polymerfolien verwendet, die erhalten werden, indem man die Kupferfolie mit einer organischen Lösung eines Polyamid-Polyamidsäure-Blockcopolymeren oder Polyamid-Polyamidsäure-Copolymeren beschichtet und die Metallbeschichtung in der Wärme unter Verdampfen des organischen Lösungsmittels in ein Polyamid-Polyimid-Blockpolymer bzw. Polyamid-Polyimid-Copolymer überführt.

Gegenstand der vorliegenden Erfindung ist somit die Verwendung von flexiblen Basismaterial zur Herstellung von flexiblen gedruckten Schaltungen, wobei das Basismaterial aus einer mit einem Polymeren ohne Zwischenschicht beschichteten Kupferfolie besteht, dadurch gekennzeichnet, dass die Polymer-Beschichtung aus einem Polyamid-Polyimid-Blockcopolymeren mit den wiederkehrenden Strukturelementen der Formel I

$$-[(A)-(E)]_n- \qquad (I)$$

worin n eine ganze Zahl von 1 bis 500, A einen Polyamidblock mit einem Grundbaustein der Formel II oder III

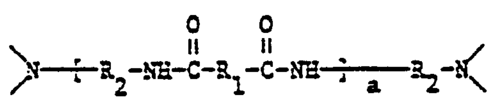

(II)

oder

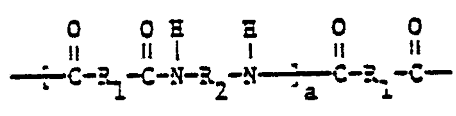

(III)

und E einen Polyimidblock mit einem Grundbaustein der Formel IV oder V

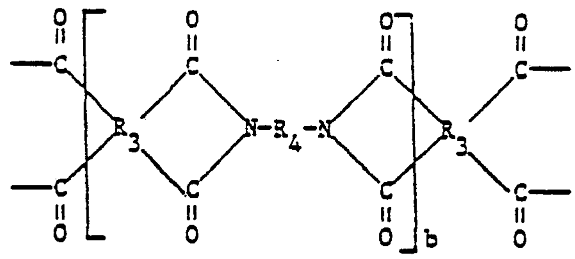

(IV)

oder

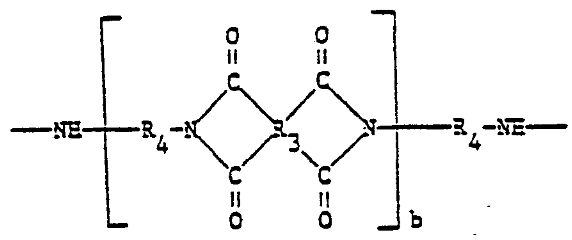

(V)

darstellen, oder aus einem Polyamid-Polyimid-Copolymeren besteht, welches erhalten wird, indem man Polyamidsäuren der Formel IVa oder Va

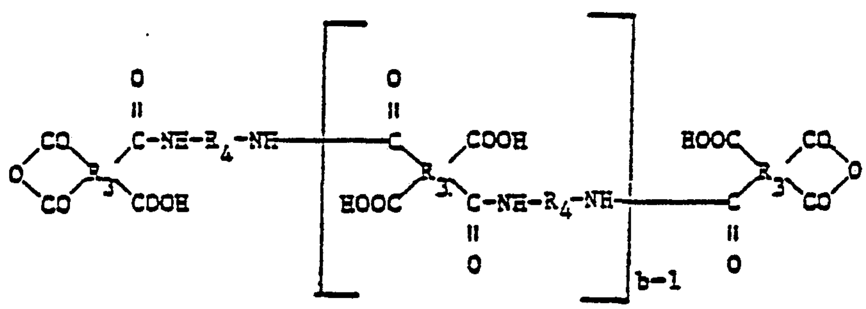

(IVa)

oder

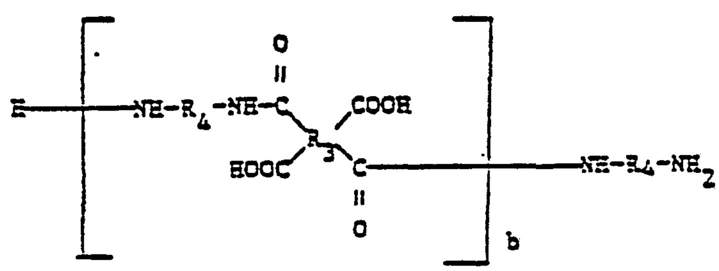

(Va)

mit Dicarbonsäuredichloriden der Formel XI

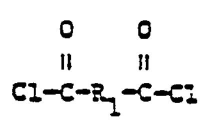

(XI)

und Diaminen der Formel XII

$$H_2N—R_2—NH_2 \quad \text{(XII)}$$

umsetzt und die so erhaltenen Polyamid-Polyamidsäure-Copolymeren anschliessend cyclisiert, und wobei in den Formeln die Symbole a und b unabhängig voneinander eine ganze Zahl von 2 bis 100, $R_2$ und $R_4$ unabhängig voneinander einen gegebenenfalls durch Halogenatome, Alkyl- oder Alkoxygruppen mit je 1-4 C-Atomen substituierten monocyclischen aromatischen Rest, einen gegebenenfalls durch Halogenatome, Alkyl- oder Alkoxygruppen mit je 1-4 C-Atomen substituierten unkondensierten bicyclischen aromatischen Rest, in dem die Aromatenkerne über —O—, $—CH_2—$ oder $—SO_2—$ miteinander verbunden sind, einen heterocyclischen Rest, Alkylen mit 2-12 C-Atomen oder einen Dicyclohexylmethanrest, $R_1$ einen aromatischen oder heterocyclischen Rest oder ein Alkylen mit 2 bis 8 C-Atomen,

wobei die Carbonylgruppen an verschiedenen Kohlenstoffatome gebunden sind, und $R_3$ einen 5- oder 6-gliedrigen Cycloalkylrest, einen Benzolring oder einen unkondensierten bicyclischen aromatischen Rest, bei dem die Aromatenkerne über das Brückenglied —O—, —CO— oder —CONH— miteinander verbunden sind und die Carbonylgruppen an verschiedene, paarweise benachbarte Ring-C-Atome gebunden sind, bedeuten.

Die auf der Kupferfolie haftende Beschichtung aus einem Polyamid-Polyimid-Blockcopolymeren besteht vorzugsweise aus einem Blockcopolymeren worin in Formel I n eine ganze Zahl von 1 bis 500, A einen Polyamidblock der Formel II oder III und E einen Polyimidblock der Formel IV oder V darstellen, wobei a und b unabhängig voneinander eine ganze Zahl von 2 bis 100 bedeuten, $R_2$ und $R_4$ unabhängig voneinander einen gegebenenfalls durch Halogenatome, Alkyl- oder Alkoxygruppen mit je 1-4 C-Atomen substituierten monocyclischen aromatischen Rest, einen gegebenenfalls durch Halogenatome, Alkyl- oder Alkoxygruppen mit je 1-4 C-Atomen substituierten unkondensierten bicyclischen aromatischen Rest, in dem die Aromatenkerne über —O—, $—CH_2—$ oder $—SO_2—$ miteinander verbunden sind oder einen heterocyclischen Rest, $R_1$ einen aromatischen oder heterocyclischen Rest, wobei die Carbonylgruppen an verschiedene Kohlenstoffatome gebunden sind, $R_3$ einen Benzolring oder einen unkondensierten bicyclischen aromatischen Rest, bei dem die Aromatenkerne über das Brückenglied —O—, —CO— oder —CONH— miteinander verbinden sind, wobei die Carbonylgruppen an verschiedene, paarweise benachbarte Ringkohlenstoffatome gebunden sind, bedeuten.

Insbesondere bestehen diese Beschichtungen aus einem Polyamid-Polyimid-Blockcopolymeren der Formel I, worin A einen Polyamidblock der Formel II und E einen Polyimidblock der Formel IV darstellen, wobei a eine ganze Zahl von 2 bis 50 und b eine ganze Zahl von 2 bis 50, insbesondere 10 bis 50, bedeuten.

In einer bevorzugten Ausführungsform verwendet man Basismaterial, dessen Beschichtungen aus einem Polyamid-Polyimid-Blockcopolymeren der Formel I besteht, worin A einen Polyamidblock der Formel II und E einen Polyimidblock der Formel IV darstellen, wobei a eine ganze Zahl von 2 bis 50 und b eine ganze Zahl von 10 bis 50 bedeuten, $R_1$ den 1,3-Phenylenrest, $R_2$ den 4,4'-Diphenyläther-, -Diphenylmethan- oder 1,3-Phenylenrest, $R_3$ einen Benzolring oder das Benzophenonringsystem, und $R_4$ den 4,4'-Diphenyläther-, 4,4'-Diphenylmethan-, 1,3- oder 1,4-Phenylenrest darstellen.

In einer weiteren bevorzugten Ausführungsform verwendet man Basismaterial, worin die auf der Kupferfolie haftende Beschichtung aus einem Polyamid-Polyimid-Copolymeren besteht, das erhalten wird, indem man eine Polyamidsäure der Formel IVa oder Va mit Dicarbonsäuredichloriden der Formel XI und Diaminen der Formel XII umsetzt, worin b eine ganze Zahl von 2-50, $R_1$—$(CH_2)$—$_4$ oder 1,3-Phenylen, vorzugsweise 1,3-Phenylen, $R_2$ 1,3-Phenylen oder den 4,4'-Diphenylätherrest, $R_3$ einen Benzolring oder das Benzophenonringsystem und $R_4$ 1,3- oder 1,4-Phenylen, den 4,4'-Diphenyläther- oder 4,4'-Diphenylmethanrest darstellen, und das erhaltene Polyamid-Polyamidsäure-Copolymere anschliessend cyclisiert.

Die erfindungsgemässe verwendeten flexiblen Basismaterialien werden erhalten, indem man eine Kupferfolie mit einer organischen Lösung eines Polyamid-Polyamidsäure-Blockcopolymeren mit dem wiederkehrenden Strukturelement der Formel VI

$$-\!\!\left[(A_1)\!-\!(E_1)\right]_n\!\!- \qquad \text{(VI)}$$

worin $A_1$ einen Polyamidblock mit einem mittleren Molekulargewicht von 350 bis 20 000 und einem Grundbaustein der Formel VII oder VIII

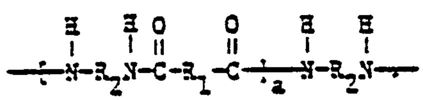

(VII)

oder

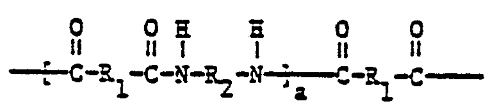

(VIII)

und $E_1$ einen Polyamidsäureblock mit einem Grundbaustein der Formel IX oder X

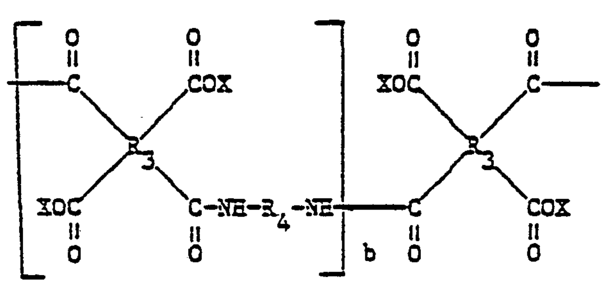

(IX)

oder

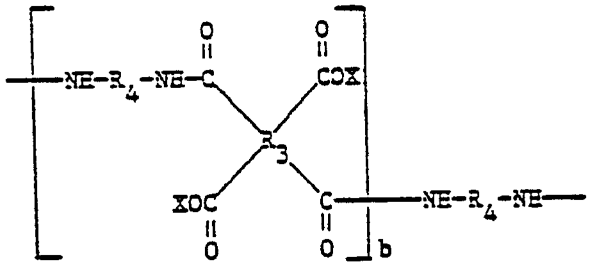

(X)

darstellen, oder einer organischen Lösung eines Polyamid-Polyamidsäure-Copolymeren, welches erhalten wird, indem man Polyamidsäuren der Formel IVa oder Va

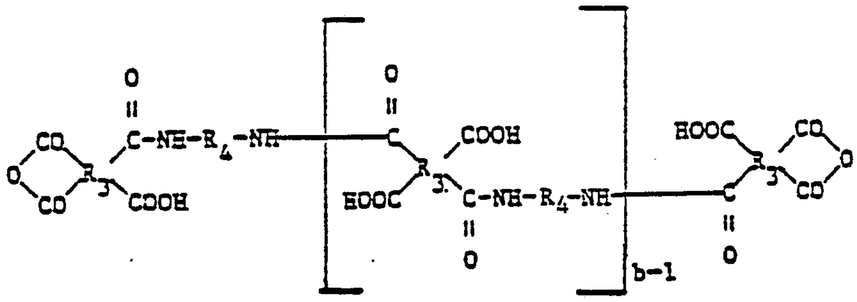

(IVa)

oder

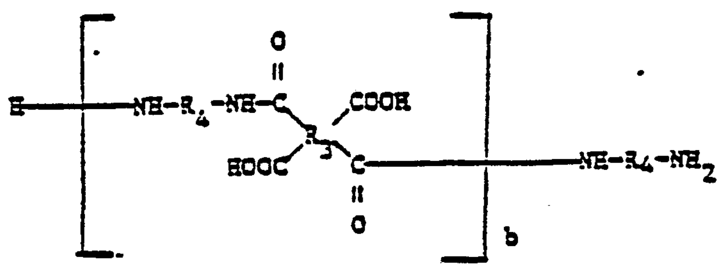

(Va)

mit Dicarbonsäuredichloriden der Formel XI

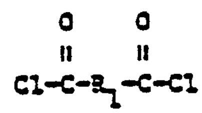

(XI)

und Diaminen der Formel XII

$$H_2N—R_2—NH_2 \qquad (XII)$$

umsetzt, wobei X je für ein Wasserstoffatom oder ein Alkyl mit 1 bis 4 C-Atomen steht, und n, a, b, $R_1$, $R_2$, $R_3$ und $R_4$ die gleiche Bedeutung wie in Formeln I bis V haben, beschichtet und anschliessend die beschichtete Metallfolie solange im Temperaturbereich von 50 bis 300 °C erhitzt, bis wenigstens eine klebfreie Beschichtung erhalten wird.

Die Cyclisierung der Polyamid-Polyamidsäure-Blockcopolymeren zu den Polyamid-Polyimid-Blockcopolymeren bzw. der Polyamid-Polyamidsäure-Copolymeren zu den Polyamid-Polyimid-Copolymeren erfolgt dabei je nach angewendeten Beschichtungsverfahren, Temperaturen und Erhitzungsdauer mehr oder weniger vollständig. Zur Erreichtung optimaler Eigenschaften ist der Schichtstoff gegebenenfalls nachträglich nochmals mehrere Stunden auf zum Beispiel 300 °C zu erhitzen.

Die zur Beschichtung von Kupferfolien verwendeten Polyamid-Polyamidsäure-Blockcopolymeren sind bekannt und können beispielsweise nach den in der DE-A-2 342 464 beschriebenen Verfahren hergestellt werden, indem man Polyamide der Formel

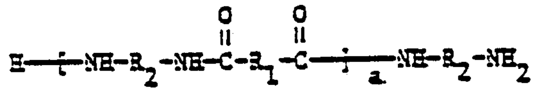

(IIa)

mit Polyamidsäuredianhydriden der Formel

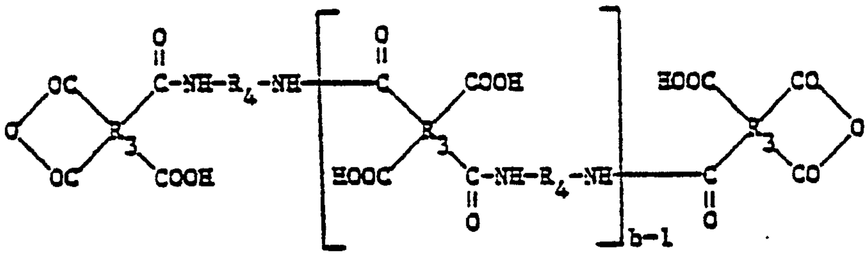

(IVa)

oder Polyamide der Formel

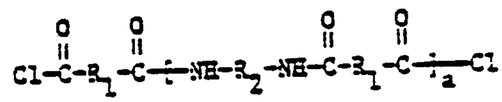

(IIIa)

mit Polyamidsäuren der Formel

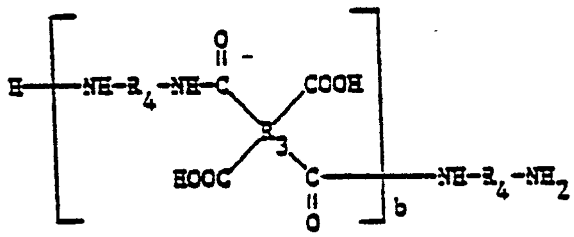

(Va)

umsetzt, wobei für a, b, $R_1$, $R_2$, $R_3$ und $R_4$ das unter den Formeln II bis V Angegebene gilt und die endständigen Anhydridgruppen in Formel IVa je an benachbarte Ring-C-Atome von $R_3$ gebunden sind.

Die Herstellung der Polyamide und Polyamidsäuren der Formeln IIa bis Va wird ebenfalls in der De-A-2 342 464 beschrieben. Die ferner zur Beschichtung von Kupferfolien verwendeten Polyamid-Polyamidsäure-Copolymeren, die einen Polyamidsäureblock der Formel IVa oder Va enthalten, sind aus der DE-A-2 342 454 bekannt.

Aus den genannten DE-A-Publikationen geht ferner hervor, dass sich die Polyamid-Polyamidsäure-Blockcopolymeren bzw. Polyamid-Polyamidsäure-Copolymeren zum Beschichten oder Verkleben von Substraten der verschiedensten Art, wie Metalle, Polymere oder Cellulosematerialien, eignen, doch lässt sich kein Hinweis entnehmen, dass sich die mit Polyamid-Polyimid-blockcopolymeren bzw. Polyamid-Polyimid-Copolymeren beschichteten Kupferfolien äusserst flexibel verhalten, das heisst, ein wiederholtes Biegen und Falten ohne Rissbildung im Polymerfilm überstehen und ausserdem eine gute Lötbadbeständigkeit sowie eine gute Beständigkeit gegenüber den in der Leiterplattentechnologie eingesetzten Lösungsmitteln aufweisen.

Die erfindungsgemäss verwendeten Polyamid-Polyamidsäure-Blockcopolymeren und Polyamid-Polyamidsäure-Copolymeren weisen im allgemeinen eine inhärente Viskosität von 0,5 bis 2,5, bzw. 0,1 bis 2,5, insbesondere 0,8 bis 1,5, auf. Die inhärente Viskosität $\eta_{inh.}$, die ein Mass für das Molekulargewicht eines Polymeren darstellt, berechnet sich nach folgender Gleichung ;

$$\eta_{inh.} = \frac{\ln \frac{\eta}{\eta_0}}{c}$$

worin

ln = natürlicher Logarithmus,

$\eta$ = Viskosität der Lösung (0,5 Gew.% des Polymeren in einem geeigneten Lösungsmittel, z. B. N,N-Dimethylacetamid, N,N-Dimethylformamid, N-Methylpyrrolidon, konz. Schwefelsäure) ;

$\eta$ = Viskosität des Lösungsmittels und

c = Konzentration der Polymerlösung in g Polymer/100 ml Lösungsmittel bedeuten.

Die Viskositätsmessungen erfolgen bei 25 °C.

Die Polyamid-Polyamidsäure-Blockcopolymeren bzw. Polyamid-Polyamidsäure-Copolymeren, die vorzugsweise in einem wasserfreien organischen Lösungsmittel und unter Feuchtigkeitsausschluss

hergestellt werden, werden vorteilhaft in Form dieser organischen Lösungen verarbeitet. Geeignete organische Lösungsmittel sind : N,N-Dimethylacetamid, N,N-Diäthylacetamid, N,N-Dimethylformamid, N,N-Dimethylmethoxyacetamid, N-Methyl-2-pyrrolidon, N-Acetyl-2-pyrrolidon, N-Methyl-ε-caprolactam, Hexamethylphosphorsäuretriamid (Hexametapol), N,N,N',N'-Tetramethylharnstoff, Tetrahydrothiophendioxid (Sulfolan) und Dimethylsulfoxid.

Es können auch Gemische solcher Lösungsmittel verwendet werden. Andererseits ist es auch möglich, diese bevorzugten Lösungsmittelsysteme mit anderen organischen aprotischen Lösungsmitteln, wie aromatischen, cycloaliphatischen oder aliphatischen, gegebenenfalls chlorierten Kohlenwasserstoffen, beispielsweise Benzol, Toluol, Xylolen, Cyclohexan, Pentan, Hexan, Petroläther, Methylenchlorid, Tetrahydrofuran, Cyclohexanon und Dioxan, zu verdünnen.

Um die Lagerstabilität der organischen Lösung der Polyamid-Polyamidsäure-Blockcopolymeren bzw. der Polyamid-Polyamidsäure-Copolymeren zu erhöhen, ist es zweckmässig, der Lösung eine wasserabsorbierende Substanz, wie zum Beispiel ein Molekularsieb, zuzugeben. Molekularsiebe werden vorteilhaft in Mengen von etwa 10 Gewichtsprozent, bezogen auf die Menge der organischen Lösung, zugesetzt. Molekularsiebe sind im Handel erhältlich, zum Beispiel als Handelsprodukt der Firma Merck.

Ueberraschenderweise wurde weiterhin gefunden, dass es vorteilhaft ist, den organischen Beschichtungslösungen, die bei höheren Temperaturen oder maschinell verarbeitet werden, vor der Verarbeitung ein Fliessmittel, z. B. « Modaflow » (Handelsprodukt der Firma Monsanto), « FC 430 » oder « FC 170 » (Handelsprodukte der Firma 3M) oder « Lodyne S 107 » (Handelsprodukt der CIBA-GEIGY) zuzugeben. Fliessmittel, oder auch Verlaufmittel genannt, sind bekanntlich Substanzen, welche die Oberflächenspannung einer Lösung reduzieren.

Die Beschichtung der Metallfolien mit den organischen Polymer-Lösungen kann sowohl von Hand als auch mit Beschichtungsmaschinen vorgenommen werden. Es können auch vertikale Beschichtungsmaschinen eingesetzt werden. Bei der maschinellen Beschichtung ist es lediglich wichtig, dass eine klebfreie Beschichtung auf der Metallfolie erhalten wird, sodass dieser Schichtstoff sich gewünschtenfalls aufrollen lässt. Zur Erzielung optimaler Eigenschaften kann dieser Schichtstoff nachträglich auf höhere Temperaturen, zum Beispiel 4 Stunden auf 180 °C und 2 Stunden auf 210 °C, erhitzt werden, wobei praktisch eine vollständige Cyclisierung der Polyamid-Polyamidsäure-Blockcopolymeren bzw. Polyamid-Polyamidsäure-Copolymeren zu den entsprechenden Polyamid-Polyimid-Blockcopolymeren bzw. Polyamid-Polyimid-Copolymeren eintritt. Die auf diese Weise beschichteten Metallfolien können direkt zur Herstellung von gedruckten Schaltungen verwendet werden, indem man die auf der Metallseite mit einem Photolack versehene Folie durch eine Photomaske belichtet und die belichtete Metallfolie in bekannter Weise entwickelt. Dabei werden flexible, gedruckte Schaltungen erhalten.

## Beispiel 1

### A. Herstellung eines Polyamidblocks mit Aminoendgruppen

In einem Sulfierkolben mit Rührer, Innenthermometer, Tropftrichter, Stickstoffeinleitungsrohr und Druckausgleichgefäss werden unter Stickstoff 7,786 g (0,072 Mol) m-Phenylendiamin in 100 g wasserfreiem N,N-Dimethylacetamid unter Rühren klar gelöst und auf —15 °C abgekühlt. Bei —15° bis —10 °C werden 12,994 g (0,064 Mol) Isophthalsäuredichlorid in fester Form portionenweise während 30 Minuten eingetragen. Anschliessend lässt man während 1 Stunde das Reaktionsgemisch bei 0 °C ausreagieren. Dann werden 12,952 g (0,128 Mol) Trimethylamin während 30 Minuten bei 0° bis 5 °C zugetropft und die Lösung eine weitere Stunde bei 5° bis 10 °C unter Rühren gehalten. Das ausgefallene Triäthylaminhydrochlorid wird durch eine Glasfritte abgenutscht und der Filterkuchen mit 40 g wasserfreiem N,N-Dimethylacetamid nachgewaschen.

### B. Herstellung eines Polyamidsäureblocks mit Anhydridendgruppen

In einer Apparatur der unter A) beschriebenen Art werden unter Stickstoff 34,9 g (0,16 Mol) Pyromellitsäuredianhydrid in 100 g wasserfreiem N,N-Dimethylacetamid unter Rühren suspendiert. Die Suspension wird unter Rühren auf —15 °C abgekühlt. Dann werden 30,436 g (0,152 Mol) 4,4'-Diaminodiphenyläther in 140 g wasserfreiem N,N-Dimethylacetamid unter Rühren klar gelöst und die Lösung bei —15° bis —10 °C während 1 Stunde zur Suspension getropft, wobei das Pyromellitsäuredianhydrid langsam in Lösung geht. Das Reaktionsgemisch wird deutlich viskos und klar. Dann wird noch 1 Stunde bei 0° bis 5 °C ausreagieren gelassen.

### C. Herstellung des Polyamid-Polyimid-Blockcopolymeren

Zu der gemäss B) erhaltenen viskosen Lösung der Polyamidsäure mit Anhydridendgruppen lässt man unter Stickstoff und heftigem Rühren die gemäss A) erhaltene Lösung des Polyamids mit Aminoendgruppen innerhalb von 5 Minuten bei 0° bis 5 °C zutropfen. Mit 100 g wasserfreiem N,N-Dimethylacetamid wird der Tropftrichter gespült und die Lösung zum Reaktionsgemisch gegeben. Unter Rühren wird homogen gemischt und 1 Stunde bei 10° bis 15 °C ausreagieren gelassen.

Man erhält eine klare, viskose, leicht gelbliche Lösung des Polyamid-Polyamidsäure-Blockcopolymeren mit einer inhärenten Viskosität von 1,08 dl/g (c = 0,5 % in N,N-Dimethylacetamid), die direkt zum Beschichten von Cu-Folien verwendet werden kann.

D. Beschichtung von Cu-Folien

Die Blockcopolymer-Lösung wird gleichmässig auf Cu-Folien verteilt und bei 70° bis 150 °C/20 mbar 7 Stunden vorgetrocknet und dabei vom Lösungsmittel befreit. Die beschichteten Cu-Folien werden anschliessend während 10 Stunden bei 200° bis 250°C/0,1 mbar einer thermischen Behandlung unterzogen, wobei die Polyamidsäureblöcke zu Polyimidblöcken cyclisiert werden. Man erhält eine gut haftende, flexible, transparente und glatte Beschichtung auf der Cu-Folie. Die erhaltene Beschichtung weist ausgezeichnete elektrische Eigenschaften auf.

Tabelle 1

Stabilität der beschichteten Cu-Folien in chlorierten Kohlenwasserstoffen bei RT. +)

| | 7 Tage | 14 Tage | 30 Tage | 60 Tage |
|---|---|---|---|---|
| Chloroform | i.O. ++) | i.O. | i.O. | i.O. |
| Chlorbenzol | i.O. | i.O. | i.O. | i.O. |
| Tetrachlorkohlenstoff | i.O. | i.O. | i.O. | i.O. |
| Dichlormethan | i.O. | i.O. | i.O. | i.O. |
| Aethylenchlorid | i.O. | i.O. | i.O. | i.O. |
| Trichloräthylen | i.O. | i.O. | i.O. | i.O. |

+) RT = Raumtemperatur
++) i.O. = in Ordnung (kein Angriff)
Aetzversuche in $FeCl_3$ : Dauer 15 Minuten ; kein Angriff. Folie : flexibel.

Zur Herstellung einer gedruckten Schaltung wurde das Laminat auf der Cu-Seite mit einem Photolack beschichtet, durch eine Photomaske belichtet, in einem chlorierten Lösungsmittel entwickelt und in $FeCl_3$ geätzt. Es resultierte eine flexible, gedruckte Schaltung mit ausgezeichneter Haftung der Leiterbahnen.

Beispiel 2

Wie in Beispiel 1 wird ein Polyamidblock hergestellt unter Verwendung von 15,572 g (0,144 Mol) m-Phenylendiamin, 25,988 g (0,128 Mol) Isophthalsäuredichlorid, 25,904 g (0,256 Mol) Triäthylamin und 195 g N-Methylpyrrolidon, sowie ein Polyamidsäureblock aus 69,800 g (0,32 Mol) Pyromellitsäureanhydrid, 60,872 g (0,304 Mol) 4,4'-Diaminodiphenyläther und 615 g N-Methylpyrrolidon. Beide Lösungen werden wie in Beispiel 1 miteinander vermischt und reagieren gelassen. Die erhaltene Lösung des Polyamid-Polyamidsäure-Blockcopolymers weist eine inhärente Viskosität von 0,98 dl/g auf, gemessen an einer 0,5 % Lösung in N-Methylpyrrolidon. Diese Copolymer-Lösung wird mit Hilfe einer Rackel (Spaltgrösse 500 μ) gleichmässig auf die mit einem TW-Treatment versehene Seite einer 35 μ dicken Kupferfolie (Handelsprodukt der Fa. Yates, Luxemburg) verteilt. Die beschichtete Folie wird waagrecht liegend in einem Umluftofen erwärmt, wobei die Temperatur stufenweise von 70 auf 170 °C erhöht wird und dann während 2 Stunden bei dieser Temperatur beibehalten wird. Bei diesem Vorgehen verdampft das Lösungsmittel und es entsteht eine Polyamid-Polyimidfolie, die sich nicht von der Kupferfolie abziehen lässt. Die Gesamtdicke dieses Schichtstoffes beträgt 60-63 μ. Trotzdem besitzt er eine ausgezeichnete thermische Stabilität ; er kann über 5 Minuten lang in ein 260 °C heisses Lötbad getaucht werden, ohne dass eine Schädigung eintritt. Dies ist wichtig, weil flexible, gedruckte Schaltungen einen Lötprozess schadlos überstehen müssen.

Der Schichtstoff besitzt weiterhin eine hervorragende Lösungsmittelbeständigkeit, insbesonders gegenüber den in der Leiterplattentechnologie angewendeten Lösungsmitteln. Die folgende Tabelle 2 gibt die Gewichtszunahme in Prozent an, die dieser aus den Blockcopolymeren und Kupfer gebildete Schichtstoff nach 15-stündiger Lagerung in diesen Lösungsmitteln bei 25 °C erleidet :

(Siehe Tabelle 2 Seite 9 f.)

Tabelle 2

| Lösungsmittel | Gewichtszunahme [%] |
|---|---|
| Dimethylformamid | 2 |
| Cyclohexanon | 0,05 |
| 1,1,1-Trichloräthan | 0,1 |
| 5%-ige Sodalösung | 0,5 |
| Wasser (dest.) | 0,09 |

Durch 60-tägige Lagerung des Schichtstoffes in den Lösungsmitteln der Tabelle 1 des Beispiels 1 geschieht keine Schädigung.

Aetzversuch in Fe $Cl_3$ : Dauer 15 Minuten ; kein Angriff

Folie : flexibel

## Beispiel 3

Wie in Beispiel 2 wird ein Polyamidblock hergestellt, wobei man an Stelle von N-Methylpyrrolidon 195 g N,N-Dimethylacetamid als Lösungsmittel verwendet und ein Polyamidsäureblock aus 69,800 g (0,32 Mol) Pyromellitsäureanhydrid, 61,600 g (0,31 Mol) 4,4'-Diaminodiphenylmethan und 615 g N,N-Dimethylacetamid. Beide Lösungen werden wie im Beispiel 1 miteinander gemischt und reagieren gelassen. Die inhärente Viskosität der Blockcopolymeren beträgt 0,85 dl/g, gemessen an einer 0,5 %-igen Lösung.

Einem Teil dieser Blockcopolymer-Lösung werden 0,2 Gewichtsteile, bezogen auf den Festkörpergehalt, des Flussmittels « Modaflow », (Handelsprodukt der Fa. Monsanto) zugesetzt, dem andern Teil wird dieses Produkt nicht zugefügt.

Beide Lösungen werden wie in Beispiel 2 beschrieben mittels einer Rakel auf die rauhe Seite von Kupferfolien gleichmässig verteilt. Die beschichteten Folien werden waagrecht liegend in einem Ofen auf 130 °C erwärmt, wobei das Lösungsmittel verdampft und ein nicht klebender Ueberzug auf Kupferfolien entsteht. Insgesamt wird der Schichtstoff 1 Stunde auf 130° und 2 Stunden auf 170 °C erwärmt.

Danach ist aus der « Modaflow » enthaltenden Lösung eine glatte, völlig gleichmässige, auf dem Kupfer sehr fest haftende Polyamid-Polyimidschicht entstanden. Aus der kein « Modaflow » enthaltenden Lösung entsteht hingegen unter diesen Herstellungsbedingungen eine ungleichmässige Polyamid-Polyimidschicht.

Die Gesamtdicke des flexiben Basismaterials mit einwandfreiem Aussehen beträgt 62 µ. Die Kupfer- und Blockcopolymer-Folien haften sehr fest aufeinander ; auch mehrfaches Knicken oder Walken bewirkt keine Schädigung. Die Lötbadbeständigkeit (260 °C) beträgt mehr als 5 Minuten.

Auf Grund seiner ausgezeichneten elektrischen Eigenschaften auch bei erhöhter Temperatur (siehe Tabelle 3) eignet sich dieser Schichtstoff für die Herstellung gedruckter, flexibler Schaltungen mit erhöhter Temperaturbeständigkeit.

Tabelle 3

| Temperatur [°C] | Spez. Durchgangswiderstand +) [Ω cm] | Dielektrischer Verlustfaktor tg δ ++) [%] |
|---|---|---|
| 23 | $2,3 \cdot 10^{15}$ | 0.45 |
| 50 | $1,7 \cdot 10^{15}$ | 0.90 |
| 80 | $6,8 \cdot 10^{14}$ | 1.29 |
| 100 | $6,3 \cdot 10^{14}$ | |
| 120 | $1,8 \cdot 10^{14}$ | |
| 150 | $1,7 \cdot 10^{15}$ | 8.13 |

+) nach DIN 53482

++) nach DIN 53483

Die vorteilhaften dielektrischen Eigenschaften werden durch die sehr geringe Frequenzabhängigkeit des dielektrischen Verlustfaktors unterstrichen (siehe Tabelle 4).

Tabelle 4

| Frequenz (Hz) | Dielektrischer Verlustfaktor tg δ (%) +) |
|---|---|
| 50 | 0,64 |
| $10^2$ | 0,59 |
| $10^3$ | 0,55 |
| $10^4$ | 0,69 |
| $10^5$ | 1,12 |
| $10^6$ | 1,19 |
| $10^7$ | 1,02 |

+) nach DIN 53483.

Der Schichtstoff besitzt eine sehr gute Lösungsmittelbeständigkeit, insbesondere gegenüber den in der Leiterplattentechnologie angewendeten Lösungsmitteln. Die Tabelle 5 gibt die Gewichtszunahme in Prozent an, die dieser Schichtstoff nach 16-stündiger Lagerung bei 25 °C in diesen Lösungsmitteln zeigt :

Tabelle 5

| Lösungsmittel | Gewichtszunahme [%] |
|---|---|
| Dimethylformamid | + 5,2 |
| Cyclohexanon | 0,0 |
| Trichloräthan | 0,0 |
| 5%-ige Sodalösung | + 0,32 |
| Wasser (dest.) | + 0,57 |

60-tägige Lagerung in den Lösungsmitteln der Tabelle 1 des Beispiels 1 bewirkt keine Schädigung.
Aetzversuch in $FeCl_3$ : Dauer 15 Minuten ; kein Angriff.
Folie : flexibel .

Beispiel 4

Wie in Beispiel 1 wird ein Polyamidblock hergestellt unter Verwendung von 187,0 g (1,73 Mol) m-Phenylendiamin, 312,0 g (1,536 7 Mol) Isophthalsäuredichlorid, 310,9 g (3,072 4 Mol) Triäthylamin in 2 820 g N,N-Dimethylacetamid, sowie ein Polyamidsäureblock aus 837,6 g (3,84 Mol) Pyromellitsäuredianhydrid, 730,5 g (3,648 Mol) 4,4'-Diaminodiphenyläther in 8 600 g N,N-Dimethylacetamid. Beide Lösungen werden wie im Beispiel 1 miteinander vermischt und reagieren gelassen. Die erhaltene Lösung des Polyamid-Polyamidsäure-Blockcopolymers weist eine inhärente Viskosität von 1,175 6 dl/g, gemessen an einer 0,5 %-igen Lösung, auf. Zu dieser Lösung wird 0,2 Gewichtsprozent « Modaflow » (bezogen auf den Festgehalt der Polyamid-Polyamidsäure-Blockcopolymerlösung) gegeben. Der Schichtstoff wurde folgendermassen hergestellt :

Eine 35 μ dicke Kupferfolie wird mit einer bestimmten Geschwindigkeit von einer Rolle abgezogen, horizontal durch einen Ofen geführt und nach dem Austritt wieder aufgewickelt. Vor dem Eintritt in den Ofen wird durch eine Dosieranlage die Lösung der Polyamid-Polyamidsäure-Blockcopolymers, in der gewünschten Dicke (z. B. 400 μ) aufgetragen. Im Ofen verdampft das Lösungsmittel und es entsteht auf

dem Kupfer eine klebfreie, festhaftende Folie. Der Schichtkörper lässt sich nach dem Durchlaufen des Ofens wieder problemlos aufwickeln. Die Geschwindigkeit des Kupferbandes und die Ofentemperatur sind so zu wählen, dass ein klebfreier Schichtstoff den Ofen verlässt. Zur Erreichung optimaler Eigenschaften kann der Schichtstoff nachträglich erhitzt werden, z. B. 4 Stunden auf 180° und 2 Stunden auf 210 °C.

Der so erhaltene Schichtstoff kann ohne Beschädigung intensiv gewalkt werden; er besitzt ausgezeichnete elektrische Eigenschaften. Tabelle 5 gibt den dielektrischen Verlustfaktor tg δ in Funktion der Temperatur an, im Vergleich zu dem im Handel erhältlichen Schichtstoff « Contiflex GT 7510 »; dieses Produkt wird durch Verkleben einer Polyimidfolie mit einer Kupferfolie hergestellt.

Tabelle 6

| Messtemperatur | Dielektrischer Verlustfaktor tg δ *) | |
|---|---|---|
| | Schichtstoff gemäss Beispiel 4 | Contiflex GT 7510 |
| [°C] | [%] | [%] |
| 23 | 0,7 | 3,4 |
| 50 | 0,75 | 9,4 |
| 80 | 0,75 | 7,3 |
| 100 | 0,85 | 4,7 |
| 130 | 1,10 | 1,11 |

*) nach DIN 53483, bei 50 Hz.

Aus Tabelle 6 ist ersichtlich, dass der dielektrische Verlustfaktor tg δ des Handelsproduktes « Contiflex » sehr temperaturabhängig und damit unvorteilhaft ist.

Nach 60-tägiger Lagerung bei Raumtemperatur in den Lösungsmitteln der Tabelle 1 des Beispiels 1 wird der erfindungsgemässe Schichtstoff nicht beschädigt. Die Lötbadbeständigkeit beträgt mehr als 5 Minuten bei 260 °C.

Beispiel 5

Wie in Beispiel 1 wird ein Polyamidblock hergestellt aus 17,844 g (0,09 Mol) 4,4'-Diaminodiphenylmethan, 16,242 g (0,08 Mol) Isophthalsäuredichlorid und 16,19 g (0,16 Mol) Triäthylamin in 180 g Dimethylacetamid, sowie ein Polyamidsäureblock aus 58,892 g (0,27 Mol) Pyromellitsäuredianhydrid und 51,550 g (0,26 Mol) 4,4'-Diaminodiphenylmethan in 600 g Dimethylacetamid.

Beide Lösungen werden wie in Beispiel 1 miteinander vermischt und reagieren gelassen. Die erhaltene Lösung des Polyamid-Polyamidsäure-Blockpolymeren besitzt eine inhärente Viskosität von 1,246 dl/g (0,5 %-ige Lösung in Dimethylacetamid: 20 °C). 740 g dieser Lösung werden mit 0,22 g « Modaflow » versetzt. Sie wird mit Hilfe einer Rackel (Spaltgrösse 500 µm), auf die rauhe Seite einer 35 µm dicken Kupferfolie aufgetragen und waagrecht liegend in einem Umlufttrockenschrank 1 Stunde auf 130°, 2 Stunden auf 180°, 3 Stunden auf 210° und 3 Stunden auf 240 °C erwärmt. Dabei bildet sich eine auf dem Kupfer festhaftende, gleichmässige Polyamid-Polyimidfolie, deren dielektrische Prüfdaten in Tabelle 7 angegeben sind.

Beispiel 6

56,71 g (0,26 Mol) Pyromellitsäuredianhydrid werden in 500 g N-Methylpyrrolidon (abgekürzt: NMP) bei 0 °C suspendiert; eine Lösung von 53,53 g (0,27 Mol) 4,4'-Diaminodiphenylmethan in 400 g NMP wird unter Rühren bei 0-5 °C zur Suspension getropf. Die entstehende klare Lösung wird bei 0-5 °C eine Stunde lang gerührt, bevor eine Lösung von 15,86 g (0,08 Mol) 4,4'-Diaminodiphenylmethan in 300 g NMP zugegeben wird. Anschliessend fügt man 18,27 g (0,09 Mol) Isophthalsäuredichlorid bei 0-5 °C portionsweise zu, lässt 30 Minuten nachreagieren, tropft dann 10,45 g (0,18 Mol) Propylenoxid zu, und lässt nochmals ca. 60 Minuten nachreagieren, bevor 0,3 g « Modaflow » zur klaren Lösung gegeben werden. Sie besitzt eine inhärente Viskosität von 1,72 dl/g (0,5 %-ige Lösung in NMP).

Wie in Beispiel 5 beschrieben wird diese Lösung zur Beschichtung einer Kupferfolie verwendet, welche zum Schluss noch 3 Stunden auf 240 °C erwärmt wird. Die dielektrischen Prüfwerte der beschichteten Kupferfolie sind in Tabelle 7 enthalten. Die Beschichtung ist frei von Oberflächenfehlern.

Beispiel 7

Wie in Beispiel 6 wird aus 56,71 g (0,26 Mol) Pyromellitsäuredianhydrid, suspendiert in 500 g NMP, und 53,53 g (0,27 Mol) 4,4'-Diaminodiphenylmethan, gelöst in 400 g NMP, eine Lösung des Polyamidsäureblocks hergestellt, zu welcher 8,65 g (0,08 Mol) m-Phenylendiamin in 200 g NMP, 18,25 g (0,09 Mol) Isophthalsäuredichlorid in 100 g NMP, 10,45 g (0,18 Mol) Propylenoxid und schliesslich 0,3 g « Modaflow » gegeben werden. Die inhärente Viskosität der Lösung beträgt 1,48 dl/g (0,5 %-ige Lösung in NMP).

Wie in Beispiel 5 beschrieben, wird diese Lösung zur Beschichtung einer Kupferfolie verwendet, welche zum Schluss noch 3 Stunden auf 240 °C erwärmt wird, die dielektrischen Prüfdaten sind in Tabelle 7 beschrieben. Die Beschichtung ist frei von Oberflächenfehlern.

Beispiel 8

Wie in Beispiel 6 wird aus 56,71 g (0,26 Mol) Pyromellitsäuredianhydrid, suspendiert in 500 g NMP, und 53,53 (0,27 Mol) 4,4'-Diaminodiphenylmethan, gelöst in 400 g NMP, eine Lösung des Polyamidsäureblocks hergestellt, zu welcher 4,325 g (0,04 Mol) m-Phenylendiamid und 7,93 g (0,04 Mol) 4,4'-Diaminodiphenylmethan in 200 g NMP, 18,25 g (0,09 Mol) Isophthalsäuredichlorid in 100 g NMP, 10,45 g Propylenoxid und schliesslich 0,3 g « Modaflow » gegeben werden. Die inhärente Viskosität der Lösung beträgt 1,24 dl/g (5 %-ige Lösung in NMP).

Wie in Beispiel 5 beschrieben, wird diese Lösung zur Beschichtung einer Kupferfolie verwendet, welche zum Schluss noch 3 Stunden auf 240 °C erwärmt wird. Die dielektrischen Prüfdaten sind in Tabelle 7 enthalten ; die Beschichtung ist frei von Oberflächenfehlern.

Beispiel 9

Wie in Beispiel 1 wird ein Polyamidblock hergestellt aus 28,08 g (0,26 Mol) m-Phenylendiamin, 50,75 g (0,25 Mol) Isophthalsäuredichlorid und 25,25 g (0,25 Mol) Triäthylamin in 350 g Dimethylacetamid, sowie ein Polyamidsäureblock aus 34,88 g (0,16 Mol) Pyromellitsäuredianhydrid und 29,70 g (0,15 Mol) 4,4'-Diaminodiphenylmethan in 300 g Dimethylacetamid. Man mischt beide klaren Lösungen und lässt sie eine Stunde reagieren. Die Lösung hat eine inhärente Viskosität von 0,90 dl/g (0,5 %-ige Lösung in Dimethylacetamid bei 20 °C).

Dieser Lösung werden 0,2 Gewichtsprozent « Modaflow » zugesetzt, danach wird sie wie im Beispiel 5 Beschichtung einer Kupferfolie verwendet. Nach dem Abdampfen des Lösungsmittels wird sie 1 Stunde auf 130°, 4 Stunden auf 180° und 3 Stunden auf 210 °C erwärmt, dabei bildet sich eine festhaftende Polyamid-Polyimidfolie, deren dielektrischen Prüfdaten in Tabelle 7 enthalten sind. Die Beschichtung ist gleichmässig, frei von sogenannten « Kratern » oder « Orangenhaut ».

Beispiel 10

In der gleichen Weise wie in Beispiel 7 wird eine Lösung eines Polyamid-Polyamidsäureblockcopolymeren hergestellt, mit der inhärenten Viskosität 1,65 dl/g (0,5 %-ige Lösung in NMP ; 20 °C).

Jeweils 150 g dieser Lösung werden mit 0,1 Gewichts-% (bezogen auf Festsubstanz) von im Handel erhältlichen Fliessmitteln « FC-170 C » bzw. « FC 430 » (Handelsprodukt der 3M-Company), bzw. mit « Lodyne S 107 » (Handelsprodukt der CIBA-GEIGY) versetzt. Jede dieser Lösungen wird zur Beschichtung einer Kupferfolie benutzt. Nach dem Abdampfen des Lösungsmittels bei etwa 120 °C wird die beschichtete Folie auf 240 °C erwärmt und 2 Stunden lang auf dieser Temperatur gehalten. Danach sind die Kupferfolien mit einer gleichmässigen Schicht des Polyamid-Polyimids überzogen.

Ohne den Zusatz dieser Fliessmittel besteht die Gefahr, dass die Beschichtung ungleichmässig ist (Bildung von « Kratern » oder « Orangenhaut »).

(Siehe Tabelle 7 Seite 13 f.)

Tabelle 7

| | Beispiel 5 | Beispiel 6 | Beispiel 7 | Beispiel 8 | Beispiel 9 | Beispiel 10 **) |
|---|---|---|---|---|---|---|
| Dielektrischer Verlustfaktor tg $\delta$ (%) *) | | | | | | |
| bei 23°C | 0,23 | 0,23 | 0,20 | 0,30 | 0,48 | 0,49 |
| 100 | 0,15 | 0,20 | 0,17 | 0,17 | 0,81 | 0,61 |
| 150 | 0,21 | 0,29 | 0,24 | 0,22 | | 0,64 |
| 200 | 0,47 | 1,01 | 0,66 | 0,60 | | 1,58 |
| 230 | 2,14 | 4,15 | 2,78 | 2,13 | | |
| Spezifischer Durchgangswiderstand ($\Omega \cdot$ cm) | | | | | | |
| bei 23°C | $3,6 \cdot 10^{16}$ | $6,9 \cdot 10^{16}$ | $6,0 \cdot 10^{16}$ | $5,5 \cdot 10^{16}$ | $9,2 \cdot 10^{15}$ | |
| 100 | $2,0 \cdot 10^{15}$ | $8,2 \cdot 10^{15}$ | $1,8 \cdot 10^{16}$ | $3,1 \cdot 10^{15}$ | $5,4 \cdot 10^{14}$ | |
| 150 | $3,4 \cdot 10^{14}$ | $6,0 \cdot 10^{15}$ | $1,3 \cdot 10^{15}$ | $9,2 \cdot 10^{14}$ | | |
| 200 | $2,7 \cdot 10^{13}$ | $9,0 \cdot 10^{13}$ | $3,3 \cdot 10^{14}$ | $1,3 \cdot 10^{14}$ | | |
| 230 | | $1,8 \cdot 10^{13}$ | $4,5 \cdot 10^{13}$ | $3,1 \cdot 10^{13}$ | | |

*) nach DIN 53482, bei 50 Hz.
**) Zusatz : 0,1 % « Lodyne S 107 ».

Tabelle 7 zeigt, dass die dielektrischen Eigenschaften der erfindungsgemässen flexiblen Laminate, in vorteilhafter Weise unabhängig sind von der Messtemperatur, verglichen mit dem in Tabelle 6 zitierten Handelsprodukt.

**Patentansprüche**

1. Verwendung von flexiblem Basismaterial zur Herstellung von flexiblen gedruckten Schaltungen, wobei das Basismaterial aus einer mit einem Polymeren ohne Zwischenschicht beschichteten Kupferfolie besteht, dadurch gekennzeichnet, dass die Polymer-Beschichtung aus einem Polyamid-Polyimid-Blockcopolymeren mit den wiederkehrenden Strukturelementen der Formel I

$$-[(A)-(E)]_n- \qquad (I)$$

worin n eine ganze Zahl von 1 bis 500, A einen Polyamidblock mit einem Grundbaustein der Formel II oder III

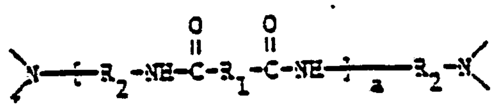

(II)

oder

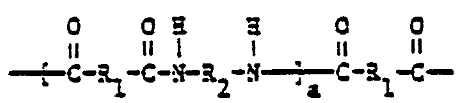

(III)

und E einen Polyimidblock mit einem Grundbaustein der Formel IV oder V

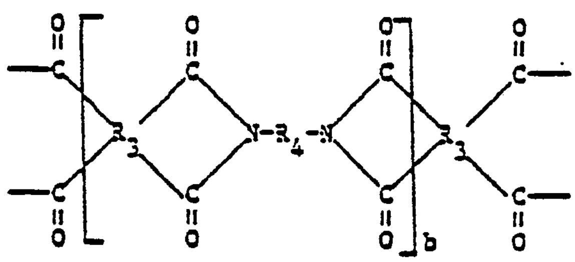

(IV)

oder

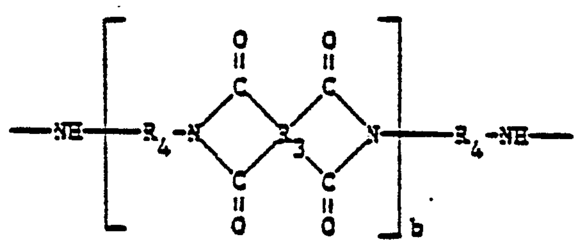

(V)

darstellen, oder aus einem Polyamid-Polyimid-Copolymeren besteht, welches erhalten wird, indem man Polyamidsäuren der Formel IVa oder Va

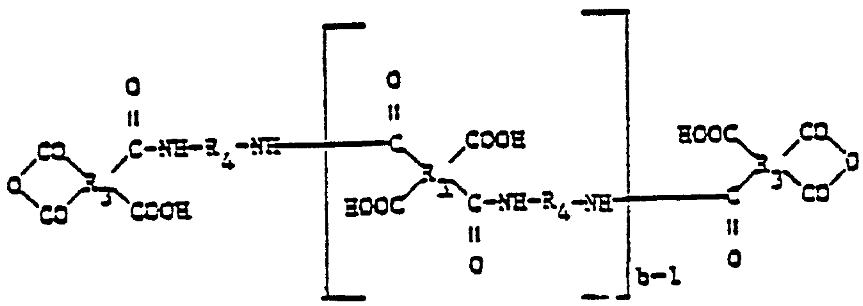

(IVa)

oder

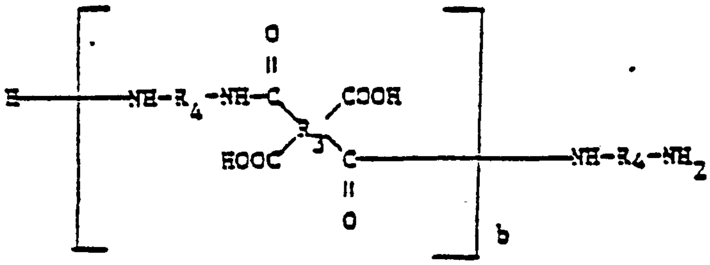

(Va)

mit Dicarbonsäuredichloriden der Formel XI

$$Cl-\overset{O}{\overset{\|}{C}}-R_1-\overset{O}{\overset{\|}{C}}-Cl \qquad (XI)$$

und Diaminen der Formel XII

$$H_2N-R_2-NH_2 \qquad (XII)$$

umsetzt und die so erhaltenen Polyamid-Polyamidsäure-Copolymeren anschliessend cyclisiert, und wobei in den Formeln a und b unabhängig voneinander eine ganze Zahl von 2 bis 100, $R_2$ und $R_4$ unabhängig voneinander einen gegebenenfalls durch Halogenatome, Alkyl- oder Alkoxygruppen mit je 1-4 C-Atomen substituierten monocyclischen aromatischen Rest, einen gegebenenfalls durch Halogenatome, Alky- oder Alkoxygruppen mit je 1-4 C-Atomen substituierten unkondensierten bicyclischen aromatischen Rest, in dem die Aromatenkerne über —O—, —$CH_2$— oder —$SO_2$— miteinander verbunden sind, einen heterocyclischen Rest, Alkylen mit 2-12 C-Atomen oder einen Dicyclohexylmethanrest, $R_1$ einen aromatischen oder heterocyclischen Rest oder ein Alkylen mit 2 bis 8 C-Atomen, wobei die Carbonylgruppen an verschiedene Kohlenstoffatome gebunden sind, und $R_3$ einen 5- oder 6-gliedrigen Cycloalkylrest, einen Benzolring oder einen unkondensierten bicyclischen aromatischen Rest, bei dem die Aromatenkerne über das Brückenglied —O—, —CO— oder —CONH— miteinander verbunden sind und die Carbonylgruppen an verschiedene, paarweise benachbarte Ring-C-Atome gebunden sind, bedeuten.

2. Verwendung gemäss Anspruch 1, dadurch gekennzeichnet, dass die Beschichtung aus einem Polyamid-Polyimid-Blockcopolymeren der Formel I besteht, worin n eine ganze Zahl von 1 bis 500, A einen Polyamidblock der Formel II oder III und E einen Polyimidblock der Formel IV oder V darstellt, wobei a und b unabhängig voneinander eine ganze Zahl von 2 bis 100 bedeuten, $R_2$ und $R_4$ unabhängig voneinander einen gegebenenfalls durch Halogenatome, Alkyl- oder Alkoxygruppen mit je 1-4 C-Atomen substituierten monocyclischen aromatischen Rest, einer gegebenenfalls durch Halogenatome, Alkyl- oder Alkoxygruppen mit je 1-4 C-Atomen substituierten unkondensierten bicyclischen aromatischen Rest, in dem die Aromatenkerne über —O—, —$CH_2$— oder —$SO_2$— miteinander verbunden sind oder einen heterocyclischen Rest, $R_1$ einen aromatischen oder heterocyclischen Rest, wobei die Carbonylgruppen an verschiedene Kohlenstoffatome gebunden sind, $R_3$ einen Benzolring oder einen unkondensierten bicyclischen aromatischen Rest, bei dem die Aromatenkerne über das Brückenglied —O—, —CO— oder —CONH— miteinander verbunden sind, wobei die Carbonylgruppen an verschiedene, paarweise benachbarte Ringkohlenstoffatome gebunden sind, bedeuten.

3. Verwendung gemäss Anspruch 1, dadurch gekennzeichnet, dass die Beschichtung aus einem Polyamid-Polyimid-Blockcopolymeren der Formel I besteht, worin A einen Polyamidblock der Formel II und E einen Polyimidblock der Formel IV darstellen, wobei a eine ganze Zahl von 2 bis 50 und b eine ganze Zahl von 2 bis 50, insbesondere 10 bis 50, bedeuten.

4. Verwendung gemäss Anspruch 1, dadurch gekennzeichnet, dass die Beschichtung aus einem Polyamid-Polyimid-Blockcopolymeren der Formel I besteht, worin A einen Polyamidblock der Formel II und E einen Polyimidblock der Formel IV darstellen, wobei a eine ganze Zahl von 2 bis 50 und b eine ganze Zahl von 10 bis 50 bedeuten, $R_1$ den 1,3-Phenylenrest, $R_2$ den 4,4'-Diphenyläther-, Diphenylmethan- oder den 1,3-Phenylenrest, $R_3$ einen Benzolring oder das Benzophenonringsystem und $R_4$ den 4,4'-Diphenyläther-, 4,4'-Diphenylmethan-, 1,3- oder 1,4-Phenylenrest darstellen.

5. Verwendung gemäss Anspruch 1, dadurch gekennzeichnet, dass die Beschichtung aus einem Polyamid-Polyimid-Copolymeren besteht, das erhalten wird, indem man eine Polyamidsäure der Formel IVa oder Va mit Dicarbonsäuredichloriden der Formel XI und Diaminen der Formel XII umsetzt, worin b eine ganze Zahl von 2-50, $R_1$ —$(CH_2)_4$— oder 1,3-Phenylen, $R_2$ 1,3-Phenylen oder den 4,4'-Diphenylätherrest, $R_3$ einen Benzolring oder das Benzophenonringsystem und $R_4$ 1,3- oder 1,4-Phenylen, den 4,4'-Diphenyläther- oder 4,4'-Diphenylmethanrest darstellen, und das erhaltene Polyamid-Polyamidsäure-Copolymere anschliessend cyclisiert.

6. Verwendung gemäss Anspruch 1, dadurch gekennzeichnet, dass man zur Polymer-Beschichtung eine mit einer wasserabsorbierenden Substanz stabilisierte organische Lösung eines Polyamid-Polyamidsäure-Blockcopolymeren verwendet.

7. Verwendung gemäss Ansprüchen 1, dadurch gekennzeichnet, dass man zur Polymer-Beschichtung eine organische Lösung eines Polyamid-Polyamidsäure-Blockcopolymeren verwendet, welche zusätzlich ein Fliessmittel enthält.

**Claims**

1. Use of a flexible base material for the preparation of flexible printed circuits, which base material consists of a copper foil coated with a polymer without an interlayer, characterised in that the polymer coating consists of a polyamide/polyimide block copolymer with recurring structural elements of the formula I

$$-[(A)-(E)]_n- \qquad (I)$$

in which n is a integer from 1 to 500, A is a polyamide block with a basic structural unit of the formula II or III

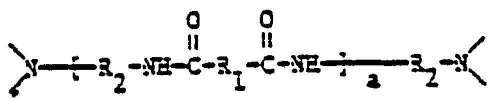

(II)

or

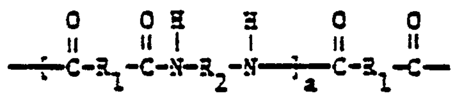

(III)

and E is a polyimide block with a basic structural unit of the formula IV or V

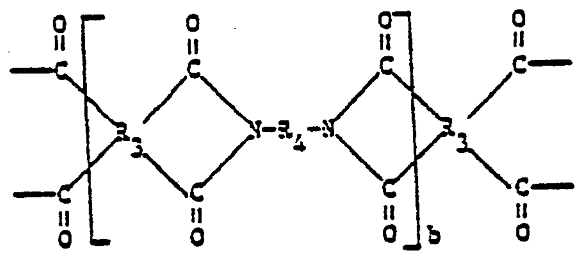

(IV)

or

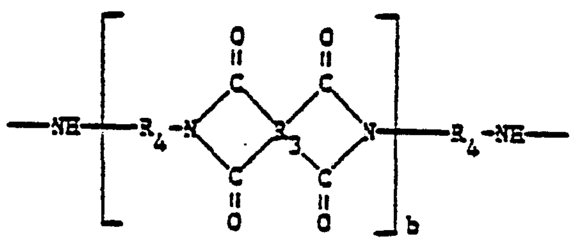

(V)

or consists of a polyamide/polyimide copolymer which is obtained by reacting a polyamide acid of the formula IVa or Va

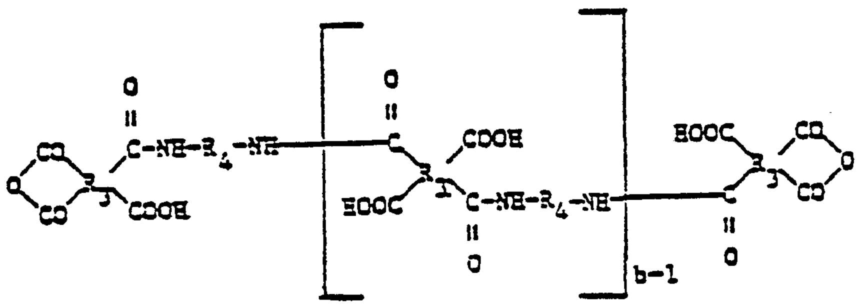

(IVa)

or

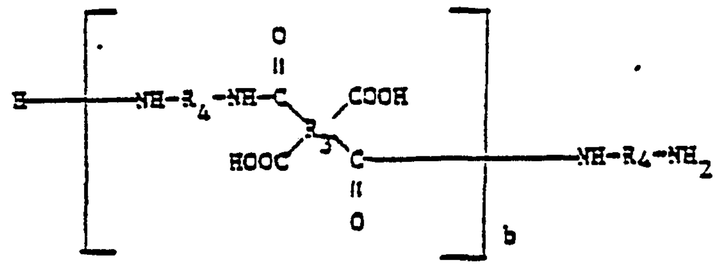

(Va)

with a dicarboxylic acid dichloride of the formula XI

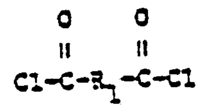

(XI)

and a diamine of the formula XII

$H_2N—R_2—NH_2$ (XII)

and subsequently cyclising the polyamide/polyamide acid copolymer thus obtained, in which formulae each of a and b independently of the other is an integer from 2 to 100, each of $R_2$ and $R_4$ independently of the other is a monocyclic aromatic radical which is unsubstituted or substituted by halogen atoms or alkyl or alkoxy groups each having 1-4 C atoms, an unfused bicyclic aromatic radical which is unsubstituted or substituted by halogen atoms or alkyl or alkoxy groups each having 1-4 C atoms and in which the aromatic nuclei are linked together via —O—, $—CH_2—$ or $—SO_2—$, or a heterocyclic radical, alkylene having 2-12 C atoms or a dicyclohexylmethane radical, $R_1$ is an aromatic or heterocyclic radical or alkylene having 2 to 8 C atoms, the carbonyl groups being bonded to different carbon atoms, and $R_3$ is a 5-membered or 6-membered cycloalkyl radical, a benzene ring or an unfused bicyclic aromatic radical in which the aromatic nuclei are linked together via the bridge member —O—, —CO— or —CONH— and the carbonyl groups are bonded to different ring C atoms which are adjacent in pairs.

2. Use according to claim 1, characterised in that the coating consists of a polyamide/polyimide block copolymer of the formula I, in which n is an integer from 1 to 500, A is a polyamide block of the formula II or III and E is a polyimide block of the formula IV or V, in which formulae each of a and b independently of the other is an integer from 2 to 100, each of $R_2$ and $R_4$ independently of the other is a monocyclic aromatic radical which is unsubstituted or substituted by halogen atoms or alkyl or alkoxy groups each having 1-4 C atoms, an unfused bicyclic aromatic radical which is unsubstituted or substituted by halogen atoms or alkyl or alkoxy groups each having 1-4 C atoms and in which the aromatic nuclei are linked together via —O—, $—CH_2—$ or $—SO_2—$, or a heterocyclic radical, $R_1$ is an aromatic or heterocyclic radical, the carbonyl groups being bonded to different carbon atoms, and $R_3$ is a benzene ring or an unfused bicyclic aromatic radical in which the aromatic nuclei are linked together via the bridge member —O—, —CO— or —CONH—, the carbonyl groups being bonded to different ring carbon atoms which are adjacent in pairs.

3. Use according to claim 1, characterised in that the coating consists of a polyamide/polyimide block copolymer of the formula I, in which A is a polyamide block of the formula II and E is a polyimide block of the formula IV, in which formulae a is an integer from 2 to 50 and b is an integer from 2 to 50, especially 10 to 50.

4. Use according to claim 1, characterised in that the coating consists of a polyamide/polyimide block copolymer of the formula I, in which A is a polyamide block of the formula II and E is a polyimide block of the formula IV, in which formulae a is an integer from 2 to 50 and b is an integer from 10 to 50, $R_1$ is a 1,3-phenylene radical, $R_2$ is a 4,4'-diphenyl ether, 4,4'-diphenylmethane or 1,3-phenylene radical, $R_3$ is a benzene ring or a benzophenone ring system and $R_4$ is a 4,4'-diphenyl ether, 4,4'-diphenylmethane, 1,3-phenylene or 1,4-phenylene radical.

5. Use according to claim 1, characterised in that the coating consists of a polyamide/polyimide copolymer which is obtained by reacting a polyamide acid of the formula IVa or Va with a dicarboxylic acid dichloride of the formula XI and a diamine of the formula XII, in which formulae b is an integer from 2-50, $R_1$ is $—(CH_2)_4—$ or 1,3-phenylene, $R_2$ is 1,3-phenylene or a 4,4'-diphenyl ether radical, $R_3$ is a benzene ring or a benzophenone ring system and $R_4$ is 1,3- or 1,4-phenylene or a 4,4'-diphenyl ether or 4,4'-diphenylmethane radical, and subsequently cyclising the polyamide/polyamide acid copolymer obtained.

6. Use according to claim 1, characterised in that an organic solution, stabilised by means of a water-absorbing substance, of a polyamide/polyamide acid block copolymer is used for polymer coating.

7. Use according to claim 1, characterised in that an organic solution, which additionally contains a flow control agent, of a polyamide/polyamide acid block copolymer is used for polymer coating.

**Revendications**

1. Application d'un matériau souple à la fabrication de circuits imprimés souples, ledit matériau étant constitué d'une feuille de cuivre revêtue d'un polymère sans couche intermédiaire, application caractérisée en ce que le revêtement de polymère est constitué d'un copolymère séquencé polyamide/polyimide comprenant des unités structurales répétées répondant à la formule I :

$$-[(A)-(E)]_n- \qquad (I)$$

dans laquelle n désigne un nombre entier de 1 à 500, A représente une séquence polyamidique comprenant une unité structurale répondant à l'une des formules II et III :

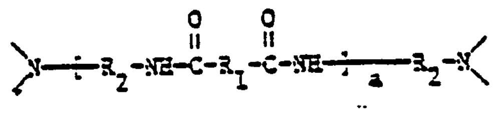
(II)

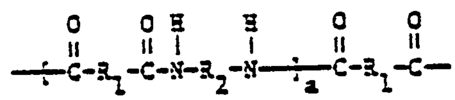
(III)

et E représente une séquence polyimidique comprenant une unité structurale répondant à l'une des formules IV et V :

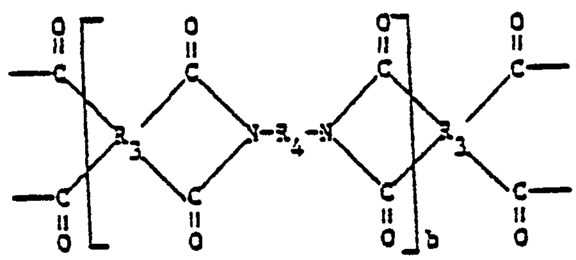
(IV)

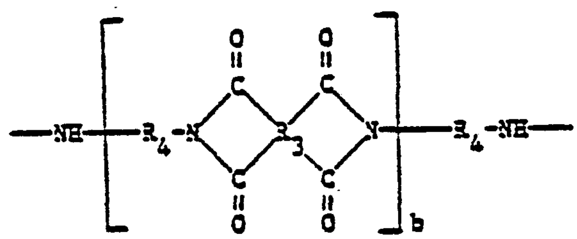
(V)

ou d'un copolymère polyamide/polyimide que l'on a obtenu en faisant réagir des polyamide-acides répondant à l'une des formules IVa et Va :

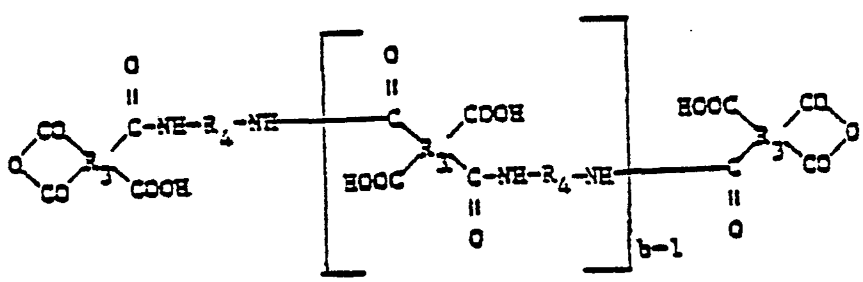
(IVa)

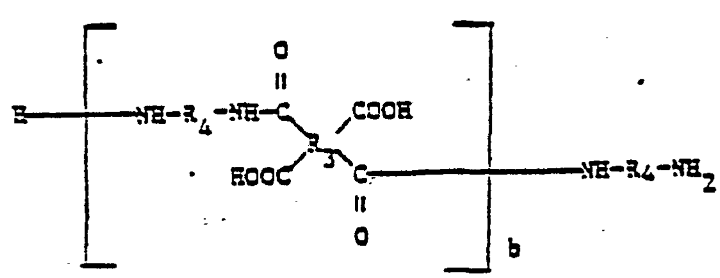
(Va)

avec des dichlorures d'acides dicarboxyliques de formule XI :

$$Cl-\overset{\overset{O}{\|}}{C}-R_1-\overset{\overset{O}{\|}}{C}-Cl \qquad (XI)$$

et des diamines de formule XII :

$$H_2N-R_2-NH_2 \qquad (XII)$$

et en cyclisant ensuite les copolymères polyamide/polyamide-acide ainsi obtenus ; dans les formules précédentes les indices a et b représentent chacun, indépendamment l'un de l'autre, un nombre entier de 2 à 100, $R_2$ et $R_4$ représentent chacun, indépendamment l'un de l'autre, un radical aromatique monocyclique éventuellement porteur d'atomes d'halogènes ou de radicaux alkyles ou alcoxy contenant chacun de 1 à 4 atomes de carbone, un radical aromatique bicyclique non condensé qui porte éventuellement des atomes d'halogènes ou des radicaux alkyles ou alcoxy contenant chacun de 1 à 4 atomes de carbone et dans lequel les noyaux aromatiques sont unis l'un à l'autre par $-O-$, $-CH_2-$ ou $-SO_2-$, un radical hétérocyclique, un radical alkylène contenant de 2 à 12 atomes de carbone ou un radical de dicyclohexylméthane, $R_1$ représente un radical aromatique ou hétérocyclique ou un radical alkylène contenant de 2 à 8 atomes de carbone qui est relié par des atomes de carbone différents aux radicaux carbonyles, et $R_3$ représente un radical de cycloalcane à 5 ou 6 maillons, un noyau de benzène ou un radical aromatique bicyclique non condensé dans lequel les noyaux aromatiques sont reliés l'un à l'autre par un pont $-O-$, $-CO-$ ou $-CONH-$ et qui porte les radicaux carbonyles sur des atomes de carbone du cycle différents et voisins par paire.

2. Application selon la revendication 1 caractérisée en ce que le revêtement est constitué d'un copolymère séquencé polyamide/polyimide de formule I dans lequel n représente un nombre entier de 1 à 500, A représente une séquence polyamidique de formule II ou III, et E représente une séquence polyimidique de formule IV ou V, formules dans lesquelles a et b représentent chacun, indépendamment l'un de l'autre, un nombre entier de 2 à 100, $R_2$ et $R_4$ représentent chacun, indépendamment l'un de l'autre, un radical aromatique monocyclique éventuellement porteur d'atomes d'halogènes ou de radicaux alkyles ou alcoxy contenant chacun de 1 à 4 atomes de carbone, un radical aromatique bicyclique non condensé qui porte éventuellement des atomes d'halogènes ou des radicaux alkyles ou alcoxy contenant chacun de 1 à 4 atomes de carbone et dans lequel les noyaux aromatiques sont unis l'un à l'autre par $-O-$, $-CH_2-$ ou $-SO_2-$, ou un radical hétérocyclique, $R_1$ représente un radical aromatique ou hétérocyclique qui est relié aux radicaux carbonyles par des atomes de carbone différents, et $R_3$ représente un noyau benzénique ou un radical aromatique bicyclique non condensé dans lequel les noyaux aromatiques sont unis l'un à l'autre par un pont $-O-$, $-CO-$ ou $-CONH-$, les radicaux carbonyles étant portés par des atomes de carbone cycliques différents, voisins par paire.

3. Application selon la revendication 1 caractérisée en ce que le revêtement est constitué d'un copolymère séquencé polyamide/polyimide de formule I dans lequel A représente une séquence polyamidique de formule II et E représente une séquence polyimidique de formule IV, l'indice a désignant un nombre entier de 2 à 50 et l'indice b un nombre entier de 2 à 50, plus particulièrement de 10 à 50.

4. Application selon la revendication 1 caractérisée en ce que le revêtement est constitué d'un copolymère séquencé polyamide/polyimide de formule I dans lequel A représente une séquence polyamidique de formule II et E une séquence polyimidique de formule IV, formules dans lesquelles a représente un nombre entier de 2 à 50, b un nombre entier de 10 à 50, $R_1$ un radical phénylène-1,3, $R_2$ un radical phénoxybenzène-4,4', diphénylméthane-4,4' ou phénylène-1,3, $R_3$ un noyau de benzène ou le système cyclique de la benzophénone et $R_4$ un radical phénoxybenzène-4,4', diphénylméthane-4,4', phénylène-1,3 ou phénylène-1,4.

5. Application selon la revendication 1 caractérisée en ce que le revêtement est constitué d'un copolymère polyamide/polyimide que l'on a obtenu en faisant réagir un polyamide-acide de formule IVa ou Va avec des dichlorures d'acides dicarboxyliques de formule XI et des diamines de formule XII, formules dans lesquelles b représente un nombre entier de 2 à 50, $R_1$ un radical $-CH_2-_4$ ou phénylène-1,3, $R_2$ un radical phénylène-1,3 ou un radical phénoxybenzène-4,4', $R_3$ un noyau de benzène ou le système cyclique de la benzophénone, et $R_4$ un radical phénylène-1,3, phénylène-1,4, phénoxybenzène-4,4' ou diphénylméthane-4,4', puis en cyclisant le copolymère polyamide/polyamide-acide obtenu.

6. Application selon la revendication 1 caractérisée en ce que, pour l'enduction avec le polymère, on utilise une solution organique d'un copolymère séquencé polyamide/polyamide-acide qui est stabilisée par une substance absorbant l'eau.

7. Application selon la revendication 1 caractérisée en ce que, pour l'enduction avec le polymère, on utilise une solution organique d'un copolymère séquencé polyamide/polyamide-acide qui contient en outre un agent d'écoulement.